# FASCICULE DE BREVET EUROPEEN

(11) **EP 0 791 933 B1**
(45) Date de publication et mention de la délivrance du brevet: **09.06.1999**
(21) Numéro de dépôt: 97460009.0
(22) Date de dépôt: 17.02.1997
(51) Int. Cl.: G11C 11/56

(54) **Mémoire non volatile multiniveau modifiable électriquement avec rafraîchissement autonome**
Elektrisch modifizierbarer nichtflüchtiger Mehrpegelspeicher mit autonomer Auffrischung
Electrically alterable multilevel nonvolatile memory with autonomous refresh

(30) Priorité: 20.02.1996 FR 9602300
(43) Date de publication de la demande: 27.08.1997
(73) Titulaire: STMicroelectronics S.A., 94250 Gentilly (FR)
(72) Inventeur: Devin, Jean, 56100 Lorient (FR)
(74) Mandataire: Schmit, Christian Norbert Marie

(56) Documents cités:
- EP-A- 0 420 388
- EP-A- 0 656 628
- US-A- 5 327 363

## Description

L'invention concerne une mémoire non volatile multiniveau modifiable électriquement comprenant des moyens de rafraîchissement autonomes. L'invention trouve plus particulièrement son application dans le domaine des mémoires de capacité importante, de l'ordre de plusieurs dizaines de mégabits.

Il existe plusieurs techniques pour augmenter la densité des mémoires. L'une d'entre elles consiste à emmagasiner plusieurs bits d'information dans une même cellule mémoire. On parle alors de mémoires multiniveau. Les mémoires classiques mémorisent un bit d'information par cellule mémoire, c'est-à-dire deux états de programmation. Ces états correspondent à la présence ou à l'absence de charges électriques dans la grille flottante des transistors constituant la cellule mémoire élémentaire. Les mémoires multiniveau, quant à elles, permettent d'emmagasiner un nombre plus important d'états de programmation par cellule mémoire.

Le brevet EP 0 340 107 décrit une mémoire multiniveau non volatile modifiable électriquement. Chaque cellule de la mémoire est capable de mémoriser n états de programmation possibles, avec n au moins égal à trois. Ces différents états de programmation sont obtenus en faisant varier le seuil de conduction du transistor à grille flottante constituant la cellule mémoire. Pour obtenir cette variation de seuil de conduction, on programme plus ou moins fortement la cellule en faisant varier l'intensité de la programmation, c'est-à-dire soit la tension appliquée à la cellule, soit la durée d'application de la tension. Pour la lecture des informations contenues dans la mémoire, on compare un courant ou une tension fonction de l'état de programmation de la cellule avec n-1 valeurs de référence principales pour en déduire l'état de programmation de la cellule mémoire parmi n états possibles.

Cependant, les phénomènes physiques mis en jeu par la programmation de telles mémoires sont mal contrôlés industriellement. Il en résulte que les courants issus des cellules de référence et des cellules programmées ne sont pas connus avec une grande précision. Ils dépendent de beaucoup de facteurs, y compris des valeurs de tension de lecture appliquées aux cellules. Le courant issu d'une cellule programmée dépend de l'intensité de la programmation, c'est-à-dire de la quantité de charges électriques injectées dans sa grille flottante. Cette quantité de charges dépend de la tension de programmation et de la durée d'application de cette tension, voire encore de la manière dont elle a été appliquée. Il existe donc une très grande dispersion entre les valeurs de courant de cellules de référence et de cellules programmées dans une série de mémoires de même fabrication.

Il arrive également que des déplacements incontrôlés de charges électriques aient lieu lors d'opérations de programmation ou d'effacement de la mémoire. Par exemple, lors de la programmation d'une cellule mémoire d'une mémoire multiniveau du type FLASH EPROM, on applique une haute tension Vpp sur la ligne de mot reliée à la grille de commande de la cellule et une tension Vp plus faible sur la ligne de bit reliée au drain de la cellule. Les sources de l'ensemble des cellules appartenant au même secteur sont reliées à la masse pendant la programmation. Les cellules reliées à la même ligne de mot sont alors soumises à un champ électrique qui peut être responsable d'un déplacement de charges électriques.

Par ailleurs, l'état de programmation d'une cellule mémoire programmée se dégrade au cours du temps, c'est-à-dire que la grille flottante des cellules mémoire a tendance à perdre des charges électriques avec le temps. La durée de rétention d'une cellule mémoire est de l'ordre de 10 ans. Pour des conditions de température élevée, cette dégradation est encore accélérée.

Enfin, un nombre important de cycles d'écriture appliquées à la cellule peut également altérer la qualité du diélectrique situé entre la grille flottante de la cellule et le substrat. Aussi, une cellule qui aura été fréquemment sollicitée risquera de perdre ou de gagner des charges électriques plus facilement qu'une autre cellule.

Toutes ces dispersions sont d'autant plus pénalisantes que, dans les mémoires multiniveau, les plages de tension ou de courant représentant les différents états de programmation sont plus restreintes du fait de leur grand nombre.

Face à toutes ces variations possibles de l'état de programmation d'une cellule, on prévoit des valeurs de référence intermédiaires. Ces valeurs de référence intermédiaires définissent des plages de sécurité qui permettent de prévenir toute perte d'un état de programmation. Elles sont utilisées pour le rafraîchissement des cellules mémoire. Pour cela, on compare le courant de lecture d'une cellule avec ces valeurs de référence intermédiaires et on détermine ainsi si la cellule doit subir une programmation complémentaire.

On constate donc que les mémoires multiniveau de type FLASH EPROM, bien qu'elles soient non volatiles, ont besoin d'être rafraîchies en permanence.

Habituellement, l'opération de rafraîchissement de la mémoire ou d'un secteur de la mémoire est effectuée sous le contrôle d'une unité de commande externe à la mémoire. Tout accès à la mémoire pendant l'opération de rafraîchissement est alors impossible.

De plus, l'opération de rafraîchissement est généralement déclenchée à la suite d'une opération d'écriture (programmation ou effacement) dans la mémoire afin de remédier aux perturbations que pourrait engendrer ce type d'opération. Ce mode de rafraîchissement ne tient pas compte des phénomènes de pertes de charges électriques avec le temps, en particulier pour les cellules mémoire qui ont été fréquemment sollicitées.

Le but de l'invention est de pallier ces inconvénients.

L'invention a pour objet un bloc mémoire non volatile modifiable électriquement comportant une première matrice de cellules mémoire non volatiles susceptibles de mémoriser au moins deux bits d'information, laquelle première matrice est divisée en secteurs, des premiers moyens d'adressage et de programmation de ladite première matrice, des premiers circuits de lecture et d'écriture associés à ladite première matrice, un circuit de commande pour commander l'ensemble, ledit bloc mémoire étant caractérisé en ce qu'il comporte, en outre, des moyens de rafraîchissement sous le contrôle du circuit de commande et une horloge temps réel délivrant des impulsions pour déclencher périodiquement une opération de rafraîchissement des cellules mémoire de ladite première matrice.

Ainsi, l'opération de rafraîchissement dans le bloc mémoire de l'invention est effectuée de manière autonome et ne nécessite aucune commande externe.

De plus, l'opération de rafraîchissement est effectuée périodiquement pour pallier tout phénomène de gain ou de perte de charges électriques au niveau de la grille flottante des cellules mémoire.

De préférence, l'opération de rafraîchissement s'effectue secteur par secteur.

Selon un mode de réalisation particulier de l'invention, la mémoire comporte une seconde matrice de cellules mémoire statiques. L'opération de rafraîchissement s'effectue alors en deux étapes :
- une étape de duplication dans la seconde matrice d'informations contenues dans un secteur de la première matrice, et
- une étape de rafraîchissement des cellules du secteur de la première matrice contenant ces informations.

Ainsi, les informations des cellules en cours de rafraîchissement sont accessibles en lecture à partir de la seconde matrice sans perturber le déroulement de l'étape de rafraîchissement.

D'autres caractéristiques et avantages de l'invention apparaîtront à la lecture de la description détaillée qui suit et qui est faite en référence aux dessins annexés dans lesquels :
- la figure 1 représente un exemple de réalisation de la mémoire selon l'invention ;
- la figure 2 représente un organigramme d'une opération de rafraîchissement du bloc mémoire selon l'invention ; et
- la figure 3 représente schématiquement une courbe de courant engendré en mode lecture par une cellule mémoire en fonction de sa programmation.

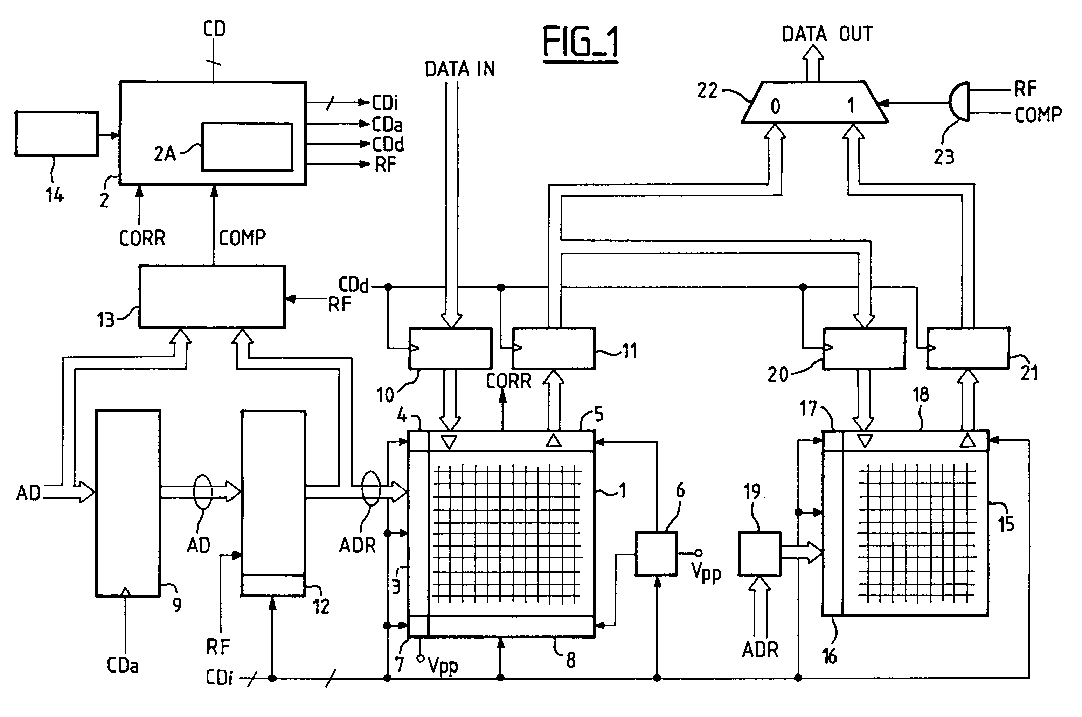

La figure 1 illustre un exemple de réalisation préféré du bloc mémoire selon l'invention. A titre d'exemple non limitatif, la mémoire multiniveau est du type FLASH EEPROM.

Le bloc mémoire comporte une matrice 1 de cellules mémoire non volatiles susceptibles de mémoriser plusieurs bits d'information. Ces cellules mémoire sont reliées à un décodeur de rangées 3 et à un décodeur de colonnes 4 lui-même associé à des circuits de lecture et d'écriture 5.

Dans le cas d'une mémoire de type FLASH EEPROM, chaque cellule est constituée d'un transistor à grille flottante dont le seuil de conduction est modifiable électriquement par l'application sur ses électrodes d'une tension appropriée. Ainsi, pour ce type de mémoire, on prévoit un générateur de tensions de programmation des colonnes 6 alimentant les drains par l'intermédiaire des circuits de lecture et d'écriture 5 et alimentant les sources par l'intermédiaire d'un circuit d'alimentation des sources 8. Il est également prévu un circuit d'alimentation des rangées 7 permettant d'appliquer sur les grilles la tension de programmation. Ces moyens d'alimentation reçoivent un potentiel Vpp délivré par un générateur dit de haute tension (non représenté).

En pratique, une mémoire FLASH EEPROM est divisée en secteurs, lesquels secteurs comportent chacun une matrice de cellules mémoire munie d'un décodeur de rangées et d'un décodeur de colonnes, de circuits de lecture et d'écriture associés ainsi que de circuits d'alimentation des rangées et des colonnes. Par souci de lisibilité, un seul secteur a été représenté sur la figure 1.

Les décodeurs 3 et 4 sont reliés à un registre d'adresses 9. Les circuits de lecture et d'écriture 5 sont reliés à un registre de données d'entrée 10 et à un registre de données de sortie 11. L'ensemble des circuits 3 à 8 est contrôlé par un circuit de commande 2.

Le circuit de commande 2 comprend des moyens de rafraîchissement 2A et est prévu pour interpréter des signaux de commande externes CD et des signaux de commande internes CORR et COMP. En fonction de cette interprétation, le circuit de commande fournit des signaux de commande CDa, CDd, CDi et RF. Selon une réalisation avantageuse, les signaux de commande internes transitent sur un bus de commande interne.

Le circuit de commande 2 est une unité programmée, par exemple du type réseau programmable logique (PLA), qui pilote l'ensemble des circuits de la mémoire comme par exemple les circuits d'alimentation 6, 7 et 8. Le circuit de commande 2 a principalement pour rôle de contrôler les opérations de lecture, de programmation et d'effacement des cellules de la mémoire.

Le bloc mémoire communique avec l'extérieur par l'intermédiaire d'un circuit d'interface (non représenté) prévu pour recevoir des commandes de lecture et d'écriture associées à des informations d'adresses, pour recevoir les données à écrire et pour délivrer les données lues.

Le circuit de commande 2 émet des signaux de contrôle CDa, CDd et CDi destinés respectivement aux registres d'adresses, aux registres de données et aux autres circuits du bloc mémoire. Un signal de rafraîchissement RF est également prévu pour indiquer qu'une opération de rafraîchissement est en cours.

Pour la mise en oeuvre de l'invention, le schéma du bloc mémoire est complété par ailleurs par un certain nombre de circuits. Tout d'abord, une horloge temps réel 14 est associée au circuit de commande 2. Cette horloge peut être sauvegardée, par exemple, par une pile au lithium intégrée à la mémoire.

L'horloge temps réel 14 délivre périodiquement des impulsions d'horloge destinées au circuit de commande 2. Chaque impulsion déclenche alors au niveau du circuit de commande 2 une opération de rafraîchissement des cellules mémoire de la matrice 1.

On prévoit également un générateur d'adresses 12 associé à chaque secteur de la matrice 1 pour produire les adresses ADR de l'ensemble des cellules du secteur pendant l'opération de rafraîchissement. Ce générateur est intercalé entre le registre d'adresses 9 et les décodeurs de lignes 3 et de colonnes 4. Quand il n'est pas sollicité pour le rafraîchissement du secteur qui lui est associé, le générateur d'adresses 12 transmet directement aux décodeurs de colonnes et de rangées l'adresse AD associée à une commande externe et, dans ce cas, l'adresse AD est égale à l'adresse ADR.

Par ailleurs, un comparateur d'adresses 13 est prévu pour comparer les adresses externes AD et les adresses ADR générées par le générateur d'adresses 12 pendant les opérations de rafraîchissement. Ce comparateur permet de déterminer si l'adresse associée à une commande externe de lecture ou d'écriture appartient au secteur de la matrice 1 en cours de rafraîchissement. Un signal de comparaison COMP représentatif du résultat de la comparaison est transmis au circuit de commande 2.

Le circuit de commande 2 reçoit également un signal de correction CORR émis par les circuits de lecture et qui a pour but de déclencher une programmation complémentaire de la cellule en cours de rafraîchissement ou un effacement du secteur suivi d'une reprogrammation. Le générateur d'adresses 12 et le comparateur 13 sont activés par le signal de rafraîchissement RF.

Selon un mode de réalisation préféré, on prévoit une seconde matrice 15 de cellules mémoire statiques organisée en rangées et en colonnes pour que les données du secteur en cours de rafraîchissement soient accessibles en lecture à partir de la seconde matrice pendant l'étape de rafraîchissement. On utilise des cellules mémoire statiques car le temps d'un cycle d'écriture dans une cellule statique est très court par rapport à celui d'une cellule dynamique ou d'une cellule non volatile redondante. Par ailleurs, la sélection des rangées de la seconde matrice s'effectue au moyen d'un décodeur de rangées 16 tandis que les colonnes sont sélectionnées par un décodeur de colonnes 17 associé à des circuits de lecture et d'écriture 18.

L'opération de rafraîchissement associée à ce type de structure s'effectue en deux étapes : une étape de duplication dans la seconde matrice des données d'un secteur de la première matrice, et une étape de rafraîchissement des cellules du secteur dupliqué de la première matrice.

L'étape de rafraîchissement d'un secteur s'effectue cellule par cellule. Le signal de correction CORR issu du circuit de lecture associé à la cellule lue est prévu pour indiquer au circuit de commande 2 si la cellule a besoin d'être corrigée. La correction consiste soit en une programmation complémentaire de la cellule, soit en un effacement puis une reprogrammation du secteur associé à la cellule.

Les décodeurs de rangées 16 de colonnes 17 reçoivent une adresse fournie par un circuit de conversion 19. Ce circuit de conversion a pour but de transformer l'adresse ADR en une adresse adaptée à la matrice 15. En effet, la taille de la matrice 15 est égale à la taille d'un secteur de la matrice 1. La nouvelle adresse issue du circuit de conversion est donc dépourvue d'indication de secteur. Par exemple, le circuit de conversion supprime les bits de l'adresse ADR indiquant un secteur de matrice, en général les bits de poids fort.

Les circuits de lecture et d'écriture 18 sont reliés avec un registre de données d'entrée 20 et un registre de données de sortie 21. Le registre de données d'entrée 20 est en relation avec le registre de données de sortie 11 pour la duplication des données du secteur à rafraîchir. Par ailleurs, un multiplexeur 22 reçoit les données en provenance des deux registres de sortie 11 et 21, et sélectionne les données à fournir en sortie de la mémoire. La sortie d'une porte ET 23 est reliée à l'entrée de sélection du multiplexeur 22. Les signaux COMP et RF sont appliqués sur les entrées de la porte ET 23. Ainsi, les données délivrées par le bloc mémoire suite à une commande externe de lecture proviennent de la matrice de cellules statiques si le secteur concerné est le secteur en cours de rafraîchissement.

En dehors des opérations de rafraîchissement, les opérations de lecture et d'écriture dans la matrice 1 s'effectuent de la même manière que pour une mémoire non volatile classique sous le contrôle du circuit de commande 2.

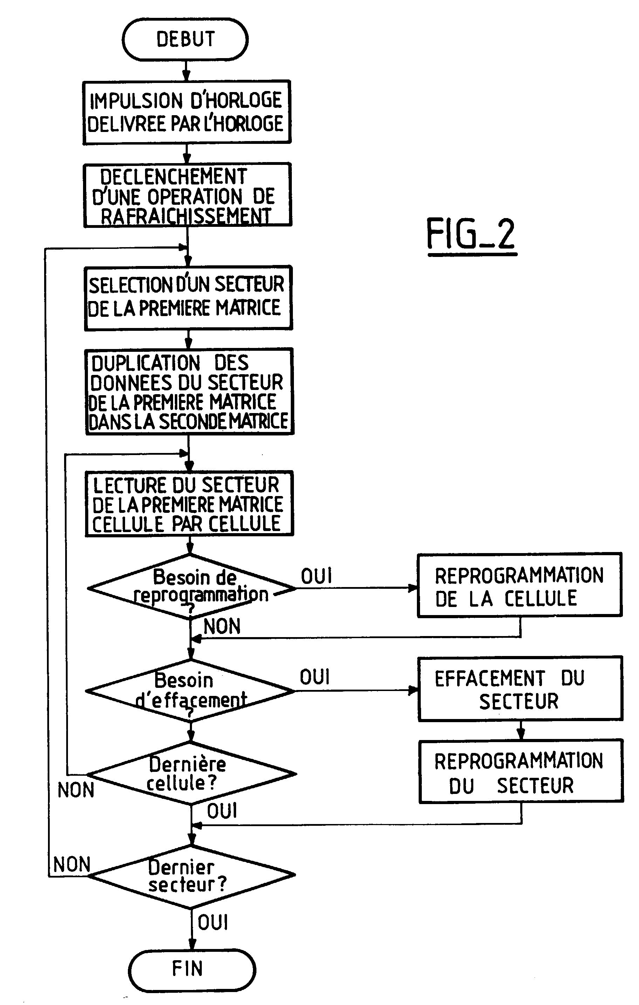

La figure 2 représente un organigramme d'une opération de rafraîchissement adaptée au bloc mémoire de la figure 1. A la suite d'un signal d'horloge délivré par l'horloge temps réel 14, le circuit de commande 2 déclenche une opération de rafraîchissement. On sélectionne un premier secteur de la matrice 1. Dans une première étape, les données du secteur sélectionné sont dupliquées dans la seconde matrice 15. Les secteurs non concernés par l'opération de rafraîchissement en cours sont accessibles en lecture et en écriture à partir de commandes externes.

L'étape de duplication est suivie d'une étape de rafraîchissement dans laquelle on vient lire les cellules du secteur sélectionné les unes après les autres. Pour ce faire, le générateur d'adresses 12 du secteur en cours de rafraîchissement fournit des adresses au décodeur de rangées 3 et au décodeur de colonnes 4. Pour déterminer l'état de programmation de la cellule lue, le courant issu de la cellule soumise à la tension de lecture est comparé à des niveaux de référence principales. Ce courant est également comparé à des niveaux de références intermédiaires pour déterminer si la cellule lue doit subir une programmation complémentaire ou être effacée puis reprogrammée.

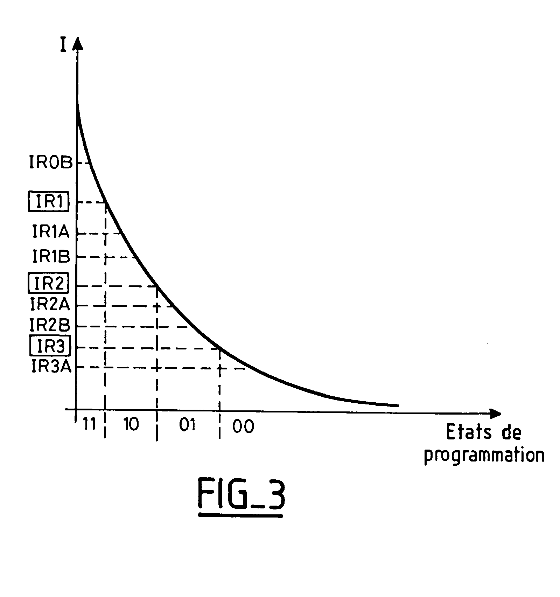

La figure 3 représente schématiquement une courbe de courant engendré en mode lecture par une cellule mémoire en fonction de sa programmation. Cette figure illustre le cas d'un bloc mémoire où les cellules sont capables de mémoriser quatre états de programmation c'est-à-dire deux bits d'information. Les valeurs de référence principales IR1, IR2 et IR3 sont des niveaux de courant permettant de définir quatre états de programmation. L'état 11 correspond à une cellule qui, en mode lecture, engendre un courant supérieur au niveau IR1. L'état 10 correspond à une cellule qui, en mode lecture, engendre un courant compris entre le niveau IR1 et le niveau IR2. L'état 01 correspond à une cellule qui, en mode lecture, engendre un courant compris entre le niveau IR2 et le niveau IR3. Enfin, l'état 00 correspond à une cellule qui, en mode lecture, engendre un courant inférieur au niveau IR3.

Des niveaux de référence intermédiaires sont également définis par des niveaux de courant IR0B, IR1A, IR1B, IR2A, IR2B et IR3A.

Ces niveaux de référence intermédiaires définissent des plages de sécurité. Dans ce type de mémoire, on considère qu'une cellule qui doit être programmée au n^{ième} état (l'état 11 est le premier état) doit non seulement fournir un courant compris entre IRn-1 et IRn mais plus précisément fournir un courant compris entre IRn-1A et IRn-1B. Si le courant de lecture de la cellule est compris entre IRn-1 et IRn-1A, on considère que la cellule est insuffisamment programmée et la cellule devra subir une programmation complémentaire. A l'inverse, si le courant de lecture de la cellule est compris entre IRn-1B et IRn, la cellule devra être effacée. L'effacement s'effectuant de manière globale dans une mémoire de type FLASH, l'ensemble du secteur contenant la cellule devra être effacé ; le secteur sera ensuite reprogrammé.

Si on se réfère de nouveau à la figure 2, chaque cellule de la matrice est ainsi lue de façon à déterminer si elle a besoin de subir une reprogrammation ou un effacement suivi d'une reprogrammation. Ces commandes de reprogrammation ou d'effacement sont transmises au circuit de commande 2 par l'intermédiaire du signal de correction CORR.

Dans le cas où la cellule est insuffisamment programmée, elle subit une programmation complémentaire par exemple sous forme d'impulsion en tension appliquée sur la grille de la cellule mémoire. On passe ensuite à la cellule suivante.

Dans le cas où la cellule a besoin d'un effacement, on efface le secteur associé à la cellule et on le reprogramme entièrement. On passe ensuite directement au secteur suivant.

L'ensemble des cellules de la matrice 1 est ainsi vérifié. A la fin de chaque étape élémentaire de rafraîchissement, le générateur d'adresses est incrémenté.

Par ailleurs, on prévoit un dispositif d'alimentation autonome (non représenté) pour alimenter le bloc mémoire afin que l'opération de rafraîchissement s'effectue normalement quand le dispositif comportant le bloc mémoire n'est pas alimenté. On pourrait envisager d'activer le dispositif d'alimentation autonome à chaque impulsion de l'horloge 14 pour une certaine durée en l'absence d'alimentation fournie par le système.

Comme on l'a vu précédemment, les données de la matrice 1 restent accessibles en lecture pendant l'opération de rafraîchissement. En effet, si on cherche à lire une donnée appartenant à un secteur différent du secteur en cours de rafraîchissement, la lecture s'effectue de manière classique sans interrompre l'opération de rafraîchissement. En revanche, si on cherche à lire une donnée mémorisée dans un secteur en cours de rafraîchissement, il y a deux cas possibles. Si la duplication du secteur de la matrice 1 est achevée, on vient lire la donnée correspondante dans la matrice 15 sinon on interrompt la duplication et on vient lire la donnée dans la matrice 1.

Par ailleurs, toute opération d'écriture (programmation ou effacement) déclenchée par une commande externe sur un secteur de la matrice 1 peut modifier l'opération de rafraîchissement de la matrice. Si l'adresse associée à la commande d'écriture pointe sur un secteur de la matrice 1 en cours de rafraîchissement, l'opération de rafraîchissement est interrompue pour laisser place à l'opération d'écriture. L'opération de rafraîchissement reprend ensuite au secteur suivant.

On pourra envisager d'insérer les moyens de rafraîchissement de l'invention dans des mémoires classiques.

Sinon, si l'opération d'écriture concerne un secteur autre que celui en cours de rafraîchissement, elle se déroule de manière classique sans interrompre l'opération de rafraîchissement.

Selon un mode de réalisation préféré, l'opération de rafraîchissement s'effectue toutes les heures.

## Revendications

1. Bloc mémoire non volatile modifiable électriquement comportant une première matrice (1) de cellules mémoire non volatiles susceptibles de mémoriser au moins deux bits d'information, laquelle première matrice est divisée en secteurs, des premiers moyens d'adressage (3, 4) et de programmation (6, 7, 8) de ladite première matrice, des premiers circuits de lecture et d'écriture (5) associés à ladite première matrice (1), un circuit de commande (2) pour commander l'ensemble, ledit bloc mémoire étant caractérisé en ce qu'il comporte, en outre, des moyens de rafraîchissement (2A) sous le contrôle du circuit de commande (2) et une horloge temps réel (14) délivrant des impulsions pour déclencher périodiquement une opération de rafraîchissement des cellules mémoire de ladite première matrice (1).

2. Bloc mémoire selon la revendication 1, caractérisé en ce que l'opération de rafraîchissement de la première matrice (1) est effectuée secteur par secteur.

3. Bloc mémoire selon l'une des revendications 1 ou 2, caractérisé en ce qu'il comporte une seconde matrice (15) de cellules mémoire statiques, des seconds moyens d'adressage (16, 17) de ladite seconde matrice (15), l'opération de rafraîchissement s'effectuant en deux étapes : une étape de duplication dans la seconde matrice (15) d'informations contenues dans la première matrice (1), et une étape de rafraîchissement des cellules mémoire de la première matrice (1) contenant cet ensemble d'informations, afin que pendant l'étape de rafraîchissement, les informations des cellules en cours de rafraîchissement soient accessibles en lecture à partir de la seconde matrice (15).

4. Bloc mémoire selon l'une des revendications 2 ou 3, caractérisé en ce que la capacité de la seconde matrice (15) est égale à la capacité d'un secteur de la première matrice (1).

5. Bloc mémoire selon l'une quelconque des revendications 1 à 4, caractérisé en ce qu'une opération de rafraîchissement est déclenchée toutes les heures.

## Patentansprüche

1. Elektrisch modifizierbarer nichtflüchtiger Speicherblock mit einer ersten Matrix (1) mit nichtflüchtigen Speicherzellen, die zum Abspeichern von wenigstens zwei Informationsbits geeignet sind, wobei die erste Matrix in Sektoren unterteilt ist, mit ersten Adreßmitteln (3, 4) und Programmiermitteln (6, 7, 8) der ersten Matrix, ersten Lese- und Schreib-Schaltkreisen (5), die zu der ersten Matrix (1) gehören, einem Steuerschaltkreis (2) zum Ansteuern der Einheit, wobei der Speicherblock dadurch gekennzeichnet ist, daß er u. a. Mittel für die Wiederauffrischung (2A) hinter der Steuerung des Steuerschaltkreises (2) und eine Echtzeituhr (14) umfaßt, die Impulse ausgibt, so daß periodisch eine Wiederauffrischungsoperation der Speicherzellen der ersten Matrix (1) ausgeführt wird.

2. Speicherblock nach Anspruch 1, dadurch gekennzeichnet, daß die Wiederauffrischungsoperation der ersten Matrix (1) Sektor für Sektor durchgeführt wird.

3. Speicherblock nach einem der Ansprüche 1 oder 2, dadurch gekennzeichnet, daß er eine zweite Matrix (15) mit statischen Speicherzellen und zweite Adreßmittel (16, 17) der zweiten Matrix (15) umfaßt, wobei die Wiederauffrischungsoperation in zwei Schritten abläuft: einem Schritt der Abbildung von Informationen, die in der ersten Matrix (1) enthalten sind in die zweite Matrix 15, und einen Schritt der Wiederauffrischung von Speicherzellen in der ersten Matrix (1), die diese Einheit von Informationen enthält, damit während des Wiederauffrischungsschrittes die Informationen von Zellen, die der Wiederauffrischung unterzogen werden, für das Lesen in der zweiten Matrix (15) zugänglich sind.

4. Speicherblock nach einem der Ansprüche 2 oder 3, dadurch gekennzeichnet, daß die Kapazität der zweiten Matrix (15) genauso groß wie die Kapazität eines Sektors der ersten Matrix (1) ist.

5. Speicherblock nach einem der Ansprüche 1 bis 4, dadurch gekennzeichnet, daß eine Wiederauffrischungsoperation jede Stunde durchgeführt wird.

## Claims

1. Electrically modifiable non-volatile memory unit having a first matrix (1) of non-volatile memory cells able to store at least two information bits, the said first matrix being divided into sectors, first means of addressing (3, 4) and programming (6, 7, 8) the said first matrix, first read and write circuits (5) associated with the said first matrix (1), and a control circuit (2) for controlling the assembly, the said memory unit being characterised in that it also has refresh means (2A) under the control of the control circuit (2) and a real-time clock (14) delivering pulses for periodically triggering an operation of refreshing the memory cells of the said first matrix (1).

2. Memory unit according to Claim 1, characterised in that the operation of refreshing the first matrix (1) is performed sector by sector.

3. Memory unit according to one of Claims 1 or 2, characterised in that it has a second matrix (15) of static memory cells, second means of addressing (16, 17) the said second matrix (15), the refresh operation being performed in two steps: a step of duplicating, in the second matrix (15), information contained in the first matrix (1), and a step of refreshing the memory cells of the first matrix (1) containing this set of information, so that, during the refresh step, the information in the cells in the course of being refreshed is accessible in read mode from the second matrix (15).

4. Memory unit according to one of Claims 2 or 3, characterised in that the capacity of the second matrix (15) is equal to the capacity of a sector of the first matrix (1).

5. Memory unit according to any one of Claims 1 to 4, characterised in that a refresh operation is triggered every hour.
